# EUROPEAN PATENT APPLICATION

(11) **EP 4 414 725 A1**
(43) Date of publication of application: **14.08.2024**
(21) Application number: 23155988.1
(22) Date of filing: 10.02.2023
(51) Int. Cl.: G01R 31/327

(54) **SYSTEM FOR MONITORING A SWITCHGEAR**

(71) Applicant: ABB SCHWEIZ AG, 5400 Baden (CH)
(72) Inventor: GITZEL, Ralf, 68165 Mannheim (DE); BOYACI, Aydin, 76137 Karlsruhe (DE); OSTROWSKI, Joerg, 8048 Zürich (CH)
(74) Representative: Maiwald GmbH

(57) **Abstract**

The present invention relates to a system (10) for monitoring a switchgear, the system comprising:
- at least one temperature sensor (20);
- at least one current sensor (30);
- a processing unit (40); and
- an output unit (50).

The at least one temperature sensor is configured to acquire temperature data for each location of at least one location of a switchgear (60) at n time points. The at least one temperature sensor is configured to provide the temperature data to the processing unit. The at least one current sensor is configured to acquire electrical current data for at least one location of the switchgear at the n time points. The at least one current sensor is configured to provide the electrical current data to the processing unit. The processing unit is configured to determine n-1 rates of change of temperature for one or more locations of the at least one location with respect to the temperature data for the one or more locations at the n time points. The processing unit is configured to determine a state of the switchgear, wherein the determination of the state of the switchgear comprises utilization of the n-1 rates of change of temperature for the one or more locations and at least n-1 of the n temperature data for the one or more locations and at least n-1 of the n electrical current data for the one or more locations. The output unit is configured to output the determined state of the switchgear when the determined state of the switchgear is determined not to be normal or not to be healthy.

## Description

### FIELD OF THE INVENTION

The present invention relates to a system for monitoring a switchgear, a method for monitoring a switchgear, to a switchgear having such a system, and a computer program element.

### BACKGROUND OF THE INVENTION

Electrical equipment such as switchgear can suffer from small faults that change the electrical resistance of the system. These faults manifest as hot spots and can ultimately lead to catastrophic failures. Here a switchgear can be a high voltage, medium voltage, or low voltage switchgear.

Thus, temperature sensors can be used to determine the state of such equipment (condition monitoring). The most commonly available sensors are thermal point sensors that measure the temperature at a specific position. A network of multiple point sensors can give a good description of the equipment's state.

One solution is to monitor parts of the switchgear, such as the phases, with an infrared thermographic camera to detect the hot spots. This is because infrared (IR) images can be used to identify technical problems within electrical equipment (e.g. switchgear) that lead to the overheating of components and to identify the hot spots themselves.

Temperature condition monitoring data can be interpretated by defining a temperature threshold for each of the phases of the equipment. If the threshold is exceeded, an alarm is raised.

However, such techniques do not provide early warnings of problems as they develop, and do not provide details on the cause of the problem.

There is a need to address these issues.

### SUMMARY OF THE INVENTION

Therefore, it would be advantageous to have an improved system for monitoring a switch gear.

The object of the present invention is solved with the subject matter of the independent claims, wherein further embodiments are incorporated in the dependent claims. It is to be noted that the system is described with respect to a switchgear, but finds utility in other electrical system than can suffer from components that overheat.

In an aspect, there is provided a system for monitoring a switchgear, the system comprising:
- at least one temperature sensor;
- at least one current sensor;
- a processing unit; and
- an output unit.
The at least one temperature sensor is configured to acquire temperature data for each location of at least one location of a switchgear at n time points. The at least one temperature sensor is configured to provide the temperature data to the processing unit. The at least one current sensor is configured to acquire electrical current data for at least one location of the switchgear at the n time points. The at least one current sensor is configured to provide the electrical current data to the processing unit. The processing unit is configured to determine n-1 rates of change of temperature for one or more locations of the at least one location with respect to the temperature data for the one or more locations at the n time points. The processing unit is configured to determine a state of the switchgear. The determination of the state of the switchgear comprises utilization of the n-1 rates of change of temperature for the one or more locations and at least n-1 of the n temperature data for the one or more locations and at least n-1 of the n electrical current data for the one or more locations. The output unit is configured to output the determined state of the switchgear when the determined state of the switchgear is determined not to be normal or not to be healthy. Here not to be healthy is equivalent to not to be normal.

Thus, temperature data for a specific location, for example that with a maximum temperature of for example a phase of a two-phase or three-phase system, is acquired along with rate of change temperature, or temperature gradient data, and electrical current data all as a function of time for the location. Thus, for example, two temperatures for a location can be acquired at two consecutive time points, from which a rate of change of temperature is determined for the location. At the same time two current measurements are made at the two time points. Then one of the two temperatures, along with the rate of change of temperature and one of the current measurement values provide enough information to determine if the operation is normal or abnormal. Here, n is equal to 2, but it can be 5, 10, 20 ... 500 etc. Thus, rather than single values of temperature, rate of change of temperature, and current flow, in effect at the same time point, a time series of the values can be utilized.

The manner in which all of this data changes with time is used to indicate if a problem is occurring at the location, for example a hot spot has developed or is in the process of developing, because this 3D data set provides a "fingerprint" that can be used to determine if the operation is normal or abnormal. The determination of normal or abnormal operation can be made using reference data in some manner, for example via a relatively simple comparison of the acquired 3D data set with reference 3D data or a more complex utilization of a trained machine learning algorithm, such as a neural network. The determination of normal or abnormal operation with respect to one part of the switch gear, for example one phase, can be made by comparing the 3D data set for this phase with equivalent data for the other phases of for example a three-phase system

To put this another way, as parts of a switchgear heat up, the temperatures and rates of temperatures of parts along with the electrical current passing through those parts provide a temporally varying 3D set of data that should change in a way that can signify that there is no problem with the parts of the switchgear.

It can also be determined from this 3D data set if overheating is caused by higher than normal current flow, or for example is caused by increased resistance along a current route, where the current flow is normal.

In an example, the at least one temperature sensor comprises one or more infrared cameras, and the temperature data for the at least one location at the n time points is determined from one or more infrared images acquired at each of the n time points.

In an example, the at least one temperature sensor comprises one or more point sensors located at the at least one location, and the temperature data for the at least one location at the n time points is acquired by the one or more point sensors at each of the n time points.

In an example, the one or more locations are determined as one or more locations with one or more maximum temperatures.

In an example, the switchgear comprises a plurality of compartments. The one or more locations comprises a plurality of locations, and each location of plurality of locations is located in a different compartment of the plurality of compartments.

In an example, the processing unit is configured to access a database of rates of change of temperature data and associated temperature data and associated electrical current data. The determination of the state of the switchgear comprises utilization of the database of rates of change of temperature data and associated temperature data and associated electrical current data.

In an example, the determination of the state of the switchgear comprises a comparison of the n-1 rates of change of temperature for the one or more locations and the at least n-1 of the n temperature data for the one or more locations and the at least n-1 of the n electrical current data for the one or more locations with the database of rates of change of temperature data and associated temperature data and associated electrical current data.

In an example, the database of rates of change of temperature and associated temperature data and associated electrical current data comprises data for the at least one location of the switchgear or an equivalent switchgear.

In an example, the database of rates of change of temperature and associated temperature data and associated electrical current data comprises data at a plurality of time points.

In an example, the processing unit is configured to implement a machine learning algorithm. The determination of the state of the switchgear comprises utilization of the machine learning algorithm, and the machine learning algorithm was trained on the basis of rates of change of temperature data and associated temperature data and associated electrical current data.

In an example, the rates of change of temperature and associated temperature data and associated electrical current data used to train the machine leaning algorithm comprises data for the at least one location of the switchgear or an equivalent switchgear.

In an example, the rates of change of temperature and associated temperature data and associated electrical current data used to train the machine learning algorithm comprises data at a plurality of time points.

In a second aspect, there is provided a method for monitoring a switchgear, the method comprising:
- acquiring by at least one temperature sensor temperature data for each location of at least one location of a switchgear at n time points;
- providing by the at least one temperature sensor the temperature data to a processing unit;
- acquiring by at least one current sensor electrical current data for at least one location of the switchgear at the n time points;
- providing by the at least one current sensor the electrical current data to the processing unit;
- determining by the processing unit n-1 rates of change of temperature for one or more locations of the at least one location with respect to the temperature data for the one or more locations at the n time points;
- determining by the processing unit a state of the switchgear, wherein the determining the state of the switchgear comprises utilizing the n-1 rates of change of temperature for the one or more locations and at least n-1 of the n temperature data for the one or more locations and at least n-1 of the n electrical current data for the one or more locations; and
- outputting by an output unit the determined state of the switchgear when the determined state of the switchgear is determined not to be normal or not to be healthy.

In a third aspect, there is provided a switchgear comprising a system according to the first aspect.

According to another aspect, there is provided a computer program element controlling one or more of the systems as previously described which, if the computer program element is executed by a processor, is adapted to perform the methods as previously described.

According to another aspect, there is provided a computer readable medium having stored a computer element as previously described.

The computer program element can for example be a software program but can also be a FPGA, a PLD or any other appropriate digital means.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows a schematic example of a system for monitoring a switchgear;
Fig. 2 shows a schematic example of a method for monitoring a switchgear; and
Fig. 3 shows a schematic example of a workflow of an embodiment a system/method for monitoring a switchgear.

### DETAILED DESCRIPTION OF EMBODIMENTS

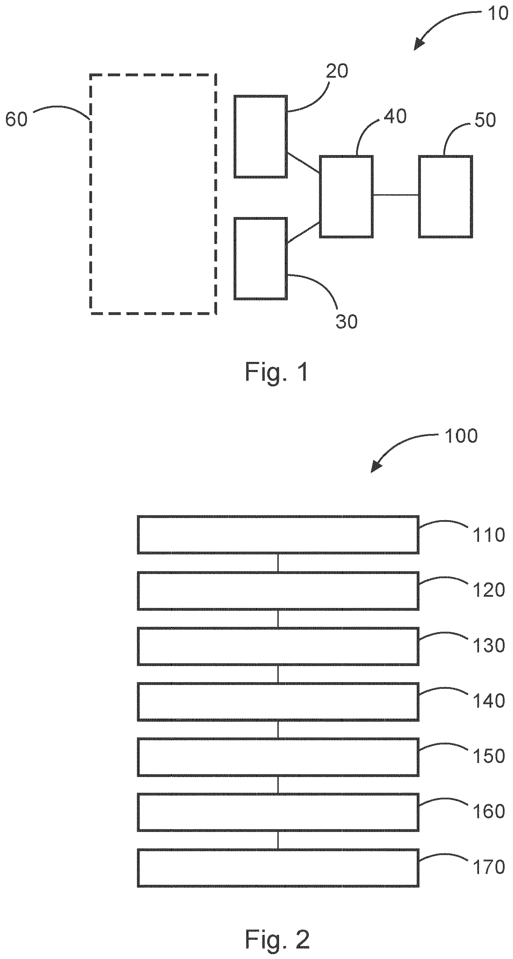

Fig. 1 shows an example of a system 10 for monitoring a switchgear. The system comprises:
- at least one temperature sensor 20;
- at least one current sensor 30;
- a processing unit 40; and
- an output unit 50.
The at least one temperature sensor is configured to acquire temperature data for each location of at least one location of a switchgear 60 at n time points. n is an integer that for example can be 2, 5, 10, 20, 50, 100, 200, 500, 1000, 2000, 5000 or a number greater than 5000 and a number between any of the number here listed. The switchgear is shown as a dotted box in Fig. 1 because it is not part of the system as such, where for example the system could be retrofitted to a switchgear or a switchgear could in effect be manufactured with such a system. The at least one temperature sensor is configured to provide the temperature data to the processing unit. The at least one current sensor is configured to acquire electrical current data for at least one location of the switchgear at the n time points. The at least one current sensor is configured to provide the electrical current data to the processing unit. The processing unit is configured to determine n-1 rates of change of temperature for one or more locations of the at least one location with respect to the temperature data for the one or more locations at the n time points. A rate of change in temperature is determined from adjacent temperature data points in time. The processing unit is configured to determine a state of the switchgear. The determination of the state of the switchgear comprises utilization of the n-1 rates of change of temperature for the one or more locations and at least n-1 of the n temperature data for the one or more location and at least n-1 of the n electrical current data for the one or more locations. The output unit is configured to output the determined state of the switchgear when the determined state of the switchgear is determined not to be normal or not to be healthy.

Thus, temperature data for a specific location, for example that with a maximum temperature of for example a phase of a two-phase or three-phase system, is acquired along with rate of change temperature, or temperature gradient data, and electrical current data all as a function of time for the location. Thus, for example, two temperatures for a location can be acquired at two consecutive time points, from which a rate of change of temperature is determined for the location. At the same time two current measurements are made at the two time points. Then one of the two temperatures, along with the rate of change of temperature and one of the current measurement values provide enough information to determine if the operation is normal or abnormal.

Here, n is equal to 2, but it can be 5, 10, 20 ... 500 etc. Thus, rather than singles values of temperature, rate of change of temperature, and current flow in effect at the same time point, a time series of the values can be utilized.

The manner in which all of this data changes with time is used to indicate if a problem is occurring at the location, for example a hot spot has developed or is in the process of developing, because this 3D data set provides a "fingerprint" that can be used to determine if the operation is normal or abnormal. The determination of normal or abnormal operation can be made using reference data in some manner, for example via a relatively simple comparison of the acquired 3D data set with reference 3D data or a more complex utilization of a trained machine learning algorithm, such as a neural network. The determination of normal or abnormal operation with respect to one part of the switch gear, for example one phase, can be made by comparing the 3D data set for this phase with equivalent data for the other phases of for example a three-phase system

To put this another way, as parts of a switchgear heat up, the temperatures and rates of temperatures of parts along with the electrical current passing through those parts provide a temporally varying 3D set of data that should change in a way that can signify that there is no problem with the parts of the switchgear.

It can also be determined from this 3D data set if overheating is caused by higher than normal current flow, or for example is caused by increased resistance along a current route, where the current flow is normal.

In an example, the determination of the state of the switchgear comprises utilization of the n-1 rates of change of temperature for the one or more locations and the n temperature data for the one or more locations at the n time points and the n electrical current data for the one or more locations at the n time points.

In an example, the at least one temperature sensor is configured to acquire temperature data for the at least one location of the switchgear at m time points, wherein m is greater than n, and wherein the n time points are consecutive time points of the m time points.

In an example, the at least one current sensor is configured to acquire electrical data for the at least one location of the switchgear at m time points, wherein m is greater than n, and wherein the n time points are consecutive time points of the m time points.

In other words, the system can in effect be acquiring temperature data and electrical current data in real time at time steps, and temperature gradient or rate of change of temperatures are determined for each temperature data point as it is acquired, for example via a comparison with the previously acquired temperature point for that location. Then a time window of n data points of temperature data and electrical current data yields n-1 temperature gradient points (that can be just one temperature value, one temperature gradient value and one electrical current value or a time series of these values), and one temperature value, one temperature gradient value and one electrical current value, or a time series of these values, is analyzed to determine a state of the switchgear.

In an example, each of the n-1 rates of change of temperature are determined for consecutive temperature data of the n temperature data for the one or more locations.

In an example, the processing unit is configured to determine n-1 correlation data points, wherein each correlation data point is a correlation between each rate of change of temperature of the n-1 rates of change of temperature with an associated temperature and an associated electrical current measurement, wherein for a particular rate of change of temperature the associated temperature is a first temperature of two temperatures used to determine the particular rate of change of temperature or is a second temperature of the two temperatures used to determine the particular rate of change of temperature or is an average of the first temperature and second temperature of the two temperatures used to determine the particular rate of change of temperature, and the electrical current measurement is one of the two electrical current measurements at the time points when the first temperature and second temperature was acquired, and wherein the determination of the state of the switchgear comprises utilization of the n-1 correlation data points, which can be a single correlation of one temperature, one rate of change of temperature and one electrical current measurement or a time series of this data..

To put this another way, as the switchgear heats up, temperature data, for example a maximum temperature within a compartment associated with a phase of a switchgear, and the associated temperature gradient data, for a particular current flow over a time window should have a specific shape with respect to actual values of temperature (T) and temperature gradient (dT) when plotted against each other. The shape of this curve, for this current value, can then be used to determine if the switchgear is heating up normally or is heating up abnormally, and there could be a hot spot developing or higher than expected current flow and now hotspot as such caused by a fault as such (loose joint or high resistance), through for example comparison with reference shape data or utilization of shape recognition capabilities in software, for example in machine learning algorithms. It is to be noted that rather than a curve, a single temperature value, temperature gradient value (rate of change of temperature) at a measured current load value is sufficient to characterize if there is a fault that will lead to overheating, or a higher than normal current but no fault as such but overheating could still occur, or indicate that everything is operating as it should. However, a time series of data can enable a clearer and more detailed characterization to be made.

In an example, the determination of the state of the switchgear comprises utilization of a shape of the n-1 correlation data points.

In an example, the output unit is configured to output the determined state of the switchgear when the determined state of the switchgear is determined to be normal or to be healthy.

In an example, the determined state of the switchgear comprises an indication that overheating is occurring.

In an example, the determined state of the switchgear comprises an indication that overheating will occur.

In an example, the determined state of the switchgear comprises an indication that overheating is occurring due to high current flow.

In an example, the determined state of the switchgear comprises an indication that overheating is occurring due to a component failure.

In an example, the component failure can be indicated as increased resistance and/or joint failure, for example based on the location of a maximum temperature.

In an example, the determined state of the switchgear comprises an indication of a location of the one or more locations.

According to an example, the at least one temperature sensor comprises one or more infrared cameras, and the temperature data for the at least one location at the n time points is determined from one or more infrared images acquired at each of the n time points.

According to an example, the at least one temperature sensor comprises one or more point sensors located at the at least one location, and the temperature data for the at least one location at the n time points is acquired by the one or more point sensors at each of the n time points.

According to an example, the one or more locations are determined as one or more locations with one or more maximum temperatures.

According to an example, the switchgear comprises a plurality of compartments. The one or more locations comprises a plurality of locations, and each location of the plurality of locations is located in a different compartment of the plurality of compartments.

According to an example, the processing unit is configured to access a database of rates of change of temperature data and associated temperature data and associated electrical current data. The determination of the state of the switchgear comprises utilization of the database of rates of change of temperature data and associated temperature data and associated electrical current data.

According to an example, the determination of the state of the switchgear comprises a comparison of the n-1 rates of change of temperature for the one or more locations and the at least n-1 of the n temperature data for the one or more locations and the at least n-1 of the n electrical current data for the one or more locations with the database of rates of change of temperature data and associated temperature data and associated electrical current data.

According to an example, the database of rates of change of temperature and associated temperature data and associated electrical current data comprises data for the at least one location of the switchgear or an equivalent switchgear.

According to an example, the database of rates of change of temperature and associated temperature data and associated electrical current data comprises data at a plurality of time points.

According to an example, the processing unit is configured to implement a machine learning algorithm. The determination of the state of the switchgear comprises utilization of the machine learning algorithm. The machine learning algorithm was trained on the basis of rates of change of temperature data and associated temperature data and associated electrical current data.

According to an example, the rates of change of temperature and associated temperature data and associated electrical current data used to train the machine leaning algorithm comprises data for the at least one location of the switchgear or an equivalent switchgear.

According to an example, the rates of change of temperature and associated temperature data and associated electrical current data used to train the machine learning algorithm comprises data at a plurality of time points.

Fig. 2 shows a method 100 for monitoring a switchgear. The method 100 comprises:
- acquiring 110 by at least one temperature sensor temperature data for each location of at least one location of a switchgear at n time points;
- providing 120 by the at least one temperature sensor the temperature data to a processing unit;
- acquiring 130 by at least one current sensor electrical current data for at least one location of the switchgear at the n time points;
- providing 140 by the at least one current sensor the electrical current data to the processing unit;
- determining 150 by the processing unit n-1 rates of change of temperature for one or more locations of the at least one location with respect to the temperature data for the one or more locations at the n time points;
- determining 160 by the processing unit a state of the switchgear, wherein the determining the state of the switchgear comprises utilizing the n-1 rates of change of temperature for the one or more locations and at least n-1 of the n temperature data for the one or more locations and at least n-1 of the n electrical current data for the one or more locations; and
- outputting 170 by an output unit the determined state of the switchgear when the determined state of the switchgear is determined not to be normal or not to be healthy.

In an example, the determining the state of the switchgear comprises utilizing the n-1 rates of change of temperature for the one or more locations and the n temperature data for the one or more locations at the n time points and the n electrical current data for the one or more locations at the n time points.

In an example, the method comprises acquiring by the at least one temperature sensor temperature data for the at least one location of the switchgear at m time points, wherein m is greater than n, and wherein the n time points are consecutive time points of the m time points.

In an example, the method comprises acquiring by the at least one current sensor electrical data for the at least one location of the switchgear at m time points, wherein m is greater than n, and wherein the n time points are consecutive time points of the m time points.

In other words, temperature data and electrical current data can be acquired in real time at time steps, and temperature gradient or rate of change of temperatures are determined for each temperature data point as it is acquired, for example via a comparison with the previously acquired temperature point for that location. Then a time window of n data points of temperature data and electrical current data yields n-1 temperature gradient points (that can be just one temperature value, one temperature gradient value and one electrical current value or a time series of these values), and one temperature value, one temperature gradient value and one electrical current value, or a time series of these values, is analyzed to determine a state of the switchgear.

In an example, each of the n-1 rates of change of temperature are determined for consecutive temperature data of the n temperature data for the one or more locations.

In an example, the method comprises determining by the processing unit n-1 correlation data points, wherein each correlation data point is a correlation between each rate of change of temperature of the n-1 rates of change of temperature with an associated temperature and an associated electrical current measurement, wherein for a particular rate of change of temperature the associated temperature is a first temperature of two temperatures used to determine the particular rate of change of temperature or is a second temperature of the two temperatures used to determine the particular rate of change of temperature or is an average of the first temperature and second temperature of the two temperatures used to determine the particular rate of change of temperature, and the electrical current measurement is one of the two electrical current measurements at the time points when the first temperature and second temperature was acquired, and wherein the determining the state of the switchgear comprises utilizing the n-1 correlation data points, which can be a single correlation of one temperature, one rate of change of temperature and one electrical current measurement or a time series of this data..

To put this another way, as the switchgear heats up, temperature data, for example a maximum temperature within a compartment associated with a phase of a switchgear, and the associated temperature gradient data, for a particular current flow over a time window should have a specific shape with respect to actual values of temperature (T) and temperature gradient (dT) when plotted against each other. The shape of this curve, for this current value, can then be used to determine if the switchgear is heating up normally or is heating up abnormally, and there could be a hot spot developing or higher than expected current flow and now hotspot as such caused by a fault as such (loose joint or high resistance), through for example comparison with reference shape data or utilization of shape recognition capabilities in software, for example in machine learning algorithms. It is to be noted that rather than a curve, a single temperature value, temperature gradient value (rate of change of temperature) at a measured current load value is sufficient to characterize if there is a fault that will lead to overheating, or a higher than normal current but no fault as such but overheating could still occur, or indicate that everything is operating as it should. However, a time series of data can enable a clearer and more detailed characterization to be made.

In an example, the determination of the state of the switchgear comprises utilization of a shape of the n-1 correlation data points.

In an example, the output unit is configured to output the determined state of the switchgear when the determined state of the switchgear is determined to be normal or to be healthy.

In an example, the determined state of the switchgear comprises an indication that overheating is occurring.

In an example, the determined state of the switchgear comprises an indication that overheating will occur.

In an example, the determined state of the switchgear comprises an indication of a location of the one or more locations.

In an example, the at least one temperature sensor comprises one or more infrared cameras, and the temperature data for the at least one location at the n time points is determined from one or more infrared images acquired at each of the n time points.

In an example, the at least one temperature sensor comprises one or more point sensors located at the at least one location, and the temperature data for the at least one location at the n time points is acquired by the one or more point sensors at each of the n time points.

In an example, the one or more locations are determined as one or more locations with one or more maximum temperatures.

In an example, the switchgear comprises a plurality of compartments, wherein the one or more locations comprises a plurality of locations, and each location of plurality of locations is located in a different compartment of the plurality of compartments.

In an example, wherein the method comprises accessing by the processing unit a database of rates of change of temperature data and associated temperature data and associated electrical current data. The determining the state of the switchgear comprises utilizing the database of rates of change of temperature data and associated temperature data and associated electrical current data.

In an example, the determining the state of the switchgear comprises comparing the n-1 rates of change of temperature for the one or more locations and the at least n-1 of the n temperature data for the one or more locations and the at least n-1 of the n electrical current data for the one or more locations with the database of rates of change of temperature data and associated temperature data and associated electrical current data.

In an example, the database of rates of change of temperature and associated temperature data and associated electrical current data comprises data for the at least one location of the switchgear or an equivalent switchgear.

In an example, the database of rates of change of temperature and associated temperature data and associated electrical current data comprises data at a plurality of time points.

In an example, the method comprises implementing by the processing unit a machine learning algorithm. The determining the state of the switchgear comprises utilizing the machine learning algorithm, and the machine learning algorithm was trained on the basis of rates of change of temperature data and associated temperature data and associated electrical current data.

In an example, the rates of change of temperature and associated temperature data and associated electrical current data used to train the machine leaning algorithm comprises data for the at least one location of the switchgear or an equivalent switchgear.

In an example, the rates of change of temperature and associated temperature data and associated electrical current data used to train the machine learning algorithm comprises data at a plurality of time points.

A switchgear 60 can comprise a system 10 as described with respect to Fig. 1.

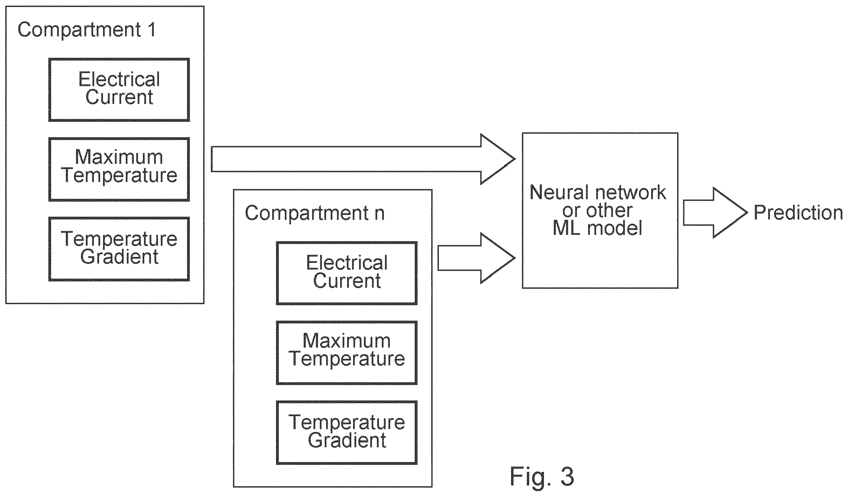

The system and method for monitoring a switchgear is described in further detail, with respect to specific embodiments, where reference is made to Fig. 3.

Fig. 3 shows a schematic representation of the new technique for monitoring a switchgear. Temperature data and rate of change of temperature, temperature gradient data, is used along with electrical current data. It was realized by the inventors that switchgear heat up can be influenced by both faults and current load, and by considering temperature data and rate of change of temperature along with electrical current data, not only can excessive heat up be detected before it becomes problematic, but it can be determined in the heat up is caused by a fault or current load.

One approach is to acquire temperature and temperature gradient data along with current load data to provide in effect a time varying three dimensional look up table, but where a single set of values at one time point (the temperature gradient values are determined from the temperatures at two consecutive time points, and the associated single temperature value can be one or these or an average and the associated current load can be that measured at one of these time points or an average). This can be compared with reference three dimensional look up tables for different current load situations, enabling it to be determined if overheating is occurring and whether it is due to the current load or if there is a fault, such as a loose joint or a higher than expected resistance within a busbar for example. Interpolation algorithms can be utilized mitigating the need to generate an excessive number of reference look up tables.

Another approach is to train a machine learning algorithm, such as a neural network on the basis of current loads and temperature and temperature gradient data for situations where a switchgear equivalent to the one operating is working correctly for different current loads. Real data can then be analyzed to determine if overheating is occurring. The machine learning algorithm can also be trained with data relating to faults, through loosening joints at different locations, and for example replacing current carrying elements, for example a busbar, with a component with an intentionally higher than normal resistance at a position along its length.

In a specific embodiment, for monitoring 4 compartments of a switchgear an infrared camera can be located to view internally within each compartment or a number of point temperature sensors can be located within each compartment, along with sensors that monitor the current loads. The system then takes the highest temperature from each compartment (4 values in this example at each time point) and additionally computes the gradient over time for each of those (another 4 values in effect at each time point). These values along with current load are used as input for a machine learning algorithm. The current load can be the current(s) of all phases or just the current of the hottest phase, or any combination of current values (avg, max).

Thus, in a specific embodiment at each time point there are n temperatures, n temperature gradients, and n or more current values that are used to describe a situation. The situation can be labeled as either healthy or faulty, and a label can be used that indicates future overheating will occur

In another exemplary embodiment, a computer program or computer program element is provided that is characterized by being configured to execute the method steps of the method according to one of the preceding embodiments, on an appropriate processor or system.

The computer program element might therefore be stored on a computer unit, which might also be part of an embodiment. This computing unit may be configured to perform or induce performing of the steps of the method described above. Moreover, it may be configured to operate the components of the above described system. The computing unit can be configured to operate automatically and/or to execute the orders of a user. A computer program may be loaded into a working memory of a data processor. The data processor may thus be equipped to carry out the method according to one of the preceding embodiments.

This exemplary embodiment of the invention covers both, a computer program that right from the beginning uses the invention and computer program that by means of an update turns an existing program into a program that uses the invention.

Further on, the computer program element might be able to provide all necessary steps to fulfill the procedure of an exemplary embodiment of the method as described above.

According to a further exemplary embodiment of the present invention, a computer readable medium, such as a CD-ROM, USB stick or the like, is presented wherein the computer readable medium has a computer program element stored on it which computer program element is described by the preceding section.

A computer program may be stored and/or distributed on a suitable medium, such as an optical storage medium or a solid state medium supplied together with or as part of other hardware, but may also be distributed in other forms, such as via the internet or other wired or wireless telecommunication systems.

However, the computer program may also be presented over a network like the World Wide Web and can be downloaded into the working memory of a data processor from such a network. According to a further exemplary embodiment of the present invention, a medium for making a computer program element available for downloading is provided, which computer program element is arranged to perform a method according to one of the previously described embodiments of the invention.

## Claims

1. A system (10) for monitoring a switchgear, the system comprising:
- at least one temperature sensor (20);
- at least one current sensor (30);
- a processing unit (40); and
- an output unit (50);
wherein the at least one temperature sensor is configured to acquire temperature data for each location of at least one location of a switchgear (60) at n time points;
wherein the at least one temperature sensor is configured to provide the temperature data to the processing unit;
wherein the at least one current sensor is configured to acquire electrical current data for at least one location of the switchgear at the n time points;
wherein the at least one current sensor is configured to provide the electrical current data to the processing unit;
wherein the processing unit is configured to determine n-1 rates of change of temperature for one or more locations of the at least one location with respect to the temperature data for the one or more locations at the n time points;
wherein the processing unit is configured to determine a state of the switchgear, wherein the determination of the state of the switchgear comprises utilization of the n-1 rates of change of temperature for the one or more locations and at least n-1 of the n temperature data for the one or more locations and at least n-1 of the n electrical current data for the one or more locations; and
wherein the output unit is configured to output the determined state of the switchgear when the determined state of the switchgear is determined not to be normal or not to be healthy.

2. System according to claim 1, wherein the at least one temperature sensor comprises one or more infrared cameras, and wherein the temperature data for the at least one location at the n time points is determined from one or more infrared images acquired at each of the n time points.

3. System according to claim 1, wherein the at least one temperature sensor comprises one or more point sensors located at the at least one location, and wherein the temperature data for the at least one location at the n time points is acquired by the one or more point sensors at each of the n time points.

4. System according to any of claims 1-3, wherein the one or more locations are determined as one or more locations with one or more maximum temperatures.

5. System according to any of claims 1-4, wherein the switchgear comprises a plurality of compartments, wherein the one or more locations comprises a plurality of locations, and wherein each location of plurality of locations is located in a different compartment of the plurality of compartments.

6. System according to any of claims 1-5, wherein the processing unit is configured to access a database of rates of change of temperature data and associated temperature data and associated electrical current data, and wherein the determination of the state of the switchgear comprises utilization of the database of rates of change of temperature data and associated temperature data and associated electrical current data.

7. System according to claim 6, wherein the determination of the state of the switchgear comprises a comparison of the n-1 rates of change of temperature for the one or more locations and the at least n-1 of the n temperature data for the one or more locations and the at least n-1 of the n electrical current data for the one or more locations with the database of rates of change of temperature data and associated temperature data and associated electrical current data.

8. System according to any of claims 6-7, wherein the database of rates of change of temperature and associated temperature data and associated electrical current data comprises data for the at least one location of the switchgear or an equivalent switchgear.

9. System according to any of claims 6-8, wherein the database of rates of change of temperature and associated temperature data and associated electrical current data comprises data at a plurality of time points.

10. System according to any of claims 1-5, wherein the processing unit is configured to implement a machine learning algorithm, and wherein the determination of the state of the switchgear comprises utilization of the machine learning algorithm, and wherein the machine learning algorithm was trained on the basis of rates of change of temperature data and associated temperature data and associated electrical current data.

11. System according to claim 10, wherein the rates of change of temperature and associated temperature data and associated electrical current data used to train the machine leaning algorithm comprises data for the at least one location of the switchgear or an equivalent switchgear.

12. System according to any of claims 10-11, wherein the rates of change of temperature and associated temperature data and associated electrical current data used to train the machine learning algorithm comprises data at a plurality of time points.

13. A method (100) for monitoring a switchgear, the method comprising:
acquiring (110) by at least one temperature sensor temperature data for each location of at least one location of a switchgear at n time points;
providing (120) by the at least one temperature sensor the temperature data to a processing unit;
acquiring (130) by at least one current sensor electrical current data for at least one location of the switchgear at the n time points;
providing (140) by the at least one current sensor the electrical current data to the processing unit;
determining (150) by the processing unit n-1 rates of change of temperature for one or more locations of the at least one location with respect to the temperature data for the one or more locations at the n time points;
determining (160) by the processing unit a state of the switchgear, wherein the determining the state of the switchgear comprises utilizing the n-1 rates of change of temperature for the one or more locations and at least n-1 of the n temperature data for the one or more locations and at least n-1 of the n electrical current data for the one or more locations; and
outputting (170) by an output unit the determined state of the switchgear when the determined state of the switchgear is determined not to be normal or not to be healthy.

14. A switchgear (60) comprising a system (10) according to any of claims 1-12.

15. A computer program element for controlling an apparatus according to any of claims 1-12 which when executed by a processor is configured to carry out the method of claim 13.
